Europäisches Patentamt

European Patent Office

Office européen des brevets

(19)

(11) EP 0 697 770 B1

## (12) EUROPÄISCHE PATENTSCHRIFT

(45) Veröffentlichungstag und Bekanntmachung des Hinweises auf die Patenterteilung:
**04.12.2002 Patentblatt 2002/49**

(51) Int Cl.$^7$: **H03M 13/00**

(21) Anmeldenummer: **95112839.6**

(22) Anmeldetag: **16.08.1995**

(54) **Verfahren zur arithmetischen Decodierung**

Arithmetic decoding method

Procédé de décodage arithmétique

(84) Benannte Vertragsstaaten:
**CH DE ES FR GB IT LI SE**

(30) Priorität: **19.08.1994 DE 4429585**

(43) Veröffentlichungstag der Anmeldung:
**21.02.1996 Patentblatt 1996/08**

(73) Patentinhaber: **ROBERT BOSCH GMBH**
**70442 Stuttgart (DE)**

(72) Erfinder:
• **Mann Pelz, Rodolfo**
**D-30175 Hannover (DE)**

• **Jannet, Bechir,**
**D-30982 Pattensen (DE)**

(56) Entgegenhaltungen:
**EP-A- 0 439 649      EP-A- 0 552 781**
**DE-A- 4 224 214**

• **IEEE TRANSACTIONS ON INFORMATION THEORY, Bd.39, Nr.5, September 1993, NEW YORK US Seiten 1514 - 1523, XP000417580 Y.S. HAN 'Efficient Priority-First Search Maximum-Likelihood Soft-Decision Decoding of Linear Block Codes'**
• **PATENT ABSTRACTS OF JAPAN vol. 17, no. 245 (E-1365) 17. Mai 1993 & JP-A-04 369 124 (OKI)**

## Beschreibung

Stand der Technik

Die Erfindung geht aus von einem Verfahren zur arithmetischen Decodierung nach der Gattung des Hauptanspruchs.

Es ist aus der Patentschrift US 5025258 bereits ein Verfahren zur arithmetischen Decodierung bekannt, bei dem eine Änderung der Verteilungsdichtefunktion der übertragenen Daten während der Übertragung erfolgt. Dazu wird sowohl auf der Empfänger- als auch auf der Senderseite eine adaptive Wahrscheinlichkeitsschätzung, d.h. eine Schätzung der Verteilungsdichtefunktion, der gesendeten bzw. der empfangenen Daten durchgeführt und die geschätzte Verteilungsdichtefunktion dem arithmetischen Encoder bzw. dem arithmetischen Decoder zur arithmetischen Encodierung bzw. zur arithmetischen Decodierung zur Verfügung gestellt. Bei der Wahrscheinlichkeitsschätzung auf der Empfängerseite werden die entschiedenen Daten berücksichtigt. Es erfolgt keine Abschätzung, ob die entschiedenen Daten aufgrund eines Übertragungsfehlers falsch entschieden wurden. Damit werden Übertragungsfehler bei der arithmetischen Decodierung nicht berücksichtigt. Dies führt zu einer höheren Fehlerrate.

Die DE-A-42 24 214 beschreibt einen erweiterten Soft-Output-Viterbi-Algorithmus, der, als innerer Decoder eingesetzt, neben decodierten Daten auch eine Zuverlässigkeitsinformation zur Verfügung stellt. Diese Zuverlässigkeitsinformationen werden durch einen nachgeschalteten äußeren Decoder, z.B. mit Reed-Solomon-Code oder Parity-Check-Code und durch A-priori-Information, die aus statistischen Eigenschaften des decodierten Signals hergeleitet werden, verbessert und dem inneren Decoder, dem damit Metrikzuschläge zur Verfügung stehen, zugefuhrt. Damit wird die Decodierung des nach dem Soft-Output-Viterbi-Algorithmus arbeitenden inneren Decoders verbessert.

Weiterhin ist es von R. Mann Pelz, "Bild- und Sprachübertragung in Mobilfunkkanälen", Nachrichtentechnik, Elektronik, Berlin 42, 1992, S. 7 ff, bekannt, bei der Kanalcodierung und der Kanaldecodierung einen Soft-Output-Viterbi-Algorithmus zu verwenden. Der Soft-Output-Viterbi-Algorithmus (SOVA) liefert eine Zuverlässigkeitsinformation, die angibt, wie groß die Wahrscheinlichkeit ist, daß das entschiedene Datum richtig entschieden wurde.

Vorteile der Erfindung

Das erfindungsgemäße Verfahren mit den Merkmalen des unabhängigen Anspruchs 1 hat demgegenüber den Vorteil, daß die kanalcodierten Daten nach dem Soft-Output-Viterbi-Algorithmus kanaldecodiert werden und somit eine erste Zuverlässigkeitsinformation über eine richtige Kanaldecodierung erhalten wird. Weiterhin wird das zu entscheidende Datum mit einem aus zuvor übertragenen Daten prädizierten Datum verglichen und bei Nichtübereinstimmung des Datums mit dem prädizierten Datum eine Änderung der Verteilungsdichtefunktion, die zur arithmetischen Decodierung verwendet wird, durchgeführt und das kanaldecodierte Datum mit der veränderten Verteilungsdichtefunktion arithmetisch decodiert. Auf diese Weise wird erreicht, daß ein z.B. durch Übertragungsfehler falsch kanaldecodiertes Datum trotzdem richtig arithmetisch decodiert wird. Damit wird ein robustes arithmetisches Decodierverfahren ermöglicht, das eine hohe Zuverlässigkeit bietet.

Durch die in den Unteransprüchen aufgeführten Maßnahmen sind vorteilhafte Weiterbildungen und Verbesserungen des im unabhängigen Anspruch angegebenen Verfahrens möglich. Besonders vorteilhaft ist es, die kanaldecodierten Daten mit unveränderter Verteilungsdichtefunktion arithmetisch zu decodieren, aus den arithmetisch decodierten Daten zeitlich folgende Daten zu prädizieren und aus den prädizierten Daten eine zweite Zuverlässigkeitsinformation abzuschätzen. Daraufhin werden die erste und die zweite Zuverlässigkeitsinformation jedes Datums miteinander verglichen und das Datum der größeren Zuverlässigkeitsinformation und die größere Zuverlässigkeitsinformation ausgewählt. Parallel wird aus dem Datum, das mit der veränderten Verteilungsdichtefunktion arithmetisch decodiert wurde, eine dritte Zuverlässigkeitsinformation abgeschätzt. Die dritte Zuverlässigkeitsinformation wird mit der ausgewählten Zuverlässigkeitsinformation verglichen und es wird das Datum als entschiedenes Datum ausgewählt, das die größere Zuverlässigkeitsinformation aufweist. Auf diese Weise wird erreicht, daß das Datum mit der größten Zuverlässigkeitsinformation als entschiedenes Datum erkannt wird. Dadurch wird die Wahrscheinlichkeit, ein richtiges Datum zu entscheiden, zusätzlich erhöht.

Weiterhin ist es von Vorteil, die Daten mittels zyklischer Blockcodes einer Kanalcodierung zu unterziehen. Auf diese Weise wird bei der Kanalcodierung mittels zyklischer Blockcodes eine Fehlerdetektion durchgeführt und ein Hinweis erhalten, ob Fehler bei der Übertragung auftreten. Dadurch wird die Zuverlässigkeit weiter erhöht.

Zeichnung

Ein Ausführungsbeispiel der Erfindung ist in der Zeichnung dargestellt und in der folgenden Beschreibung näher erläutert. Es zeigen Figur 1 eine Übertragungsstrecke, Figur 2 einen schematischen Programmablauf, Figur 3 Bildpunkte und Figur 4 eine schematische Darstellung der arithmetischen Decodierung.

Beschreibung des Ausführungsbeispiels

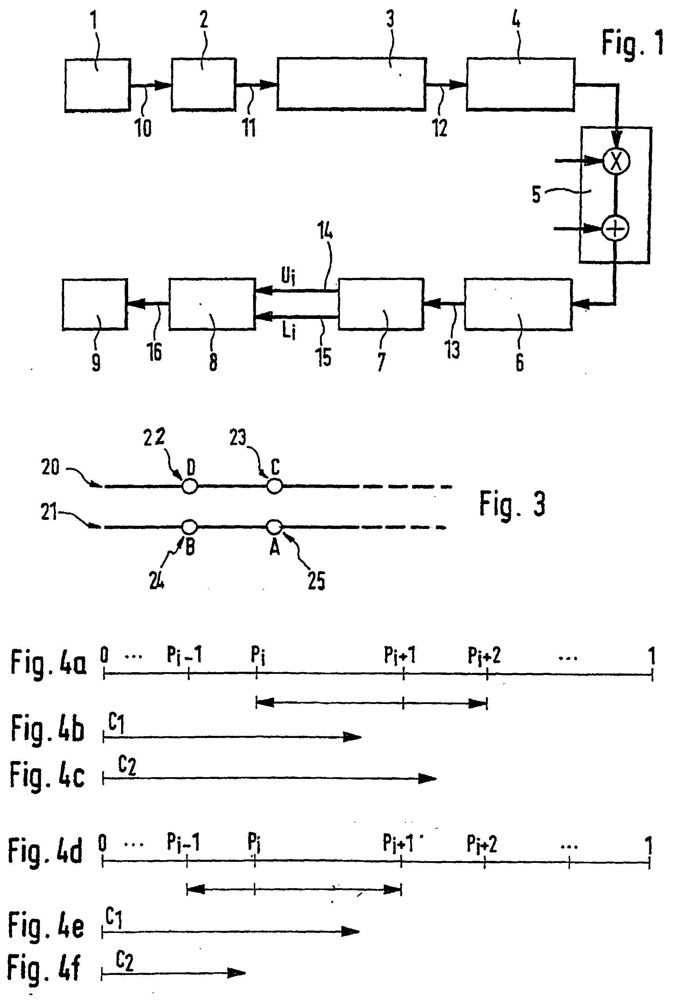

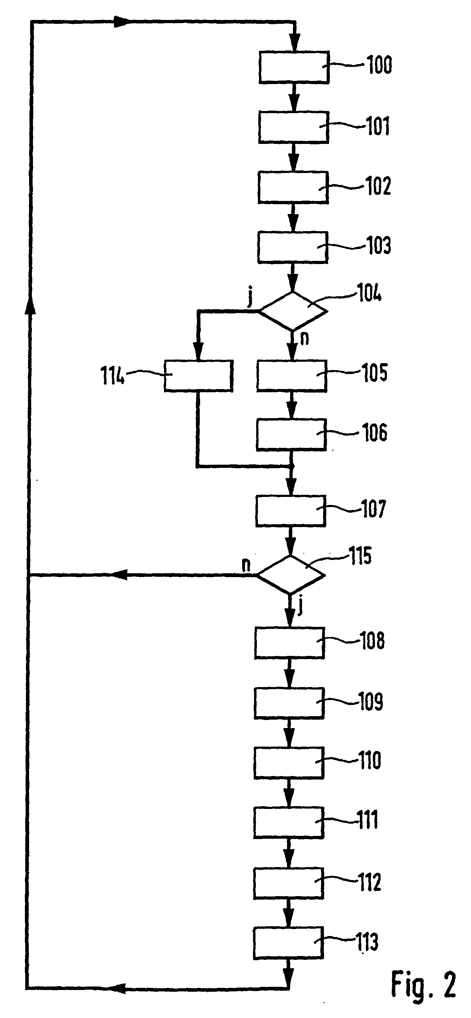

Figur 1 zeigt schematisch eine Übertragungsstrecke. Von der Datenquelle 1 werden Bilddaten in digitaler Form geliefert. Die von der Datenquelle 1 gelieferten Daten könnten jedoch auch andere Informationen wie z.B. Sprache beinhalten. Als Bilddaten werden z.B. Helligkeitsinformationen von Bildpixeln übertragen. Die Bilddaten werden von der Datenquelle 1 über eine erste Datenleitung 10 an einen arithmetischen Coder 2 geleitet. Der arithmetische Coder 2 führt eine arithmetische Codierung der Bilddaten durch.

Arithmetische Codierverfahren sind bereits bekannt und z.B. bei I.H. Witten, et al., Arithmetic Coding for Datacompression", Communications of the ACM, Computing Practices, June 1987, Volume 30, No. 6, S. 520 ff beschrieben.

Die arithmetisch codierten Bilddaten werden über eine erste Coderleitung 11 vom arithmetischen Coder 2 an einen Kanalcoder 3 geführt. Der Kanalcoder 3 führt eine Faltungscodierung der zugeführten Daten durch. Anschließend werden die faltungscodierten Daten über eine zweite Coderleitung 12 an einen Interleaver 4 gegeben. Der Interleaver 4 führt ein Interleaving der zugeführten Daten durch und gibt die verarbeiteten Daten an einen Übertragungskanal 5. Vom Übertragungskanal 5 werden die Daten an einen Deinterleaver 6 gegeben. Der Deinterleaver 6 führt ein zum Interleaver 4 inverses Interleavingverfahren durch. Anschließend werden die Daten über eine dritte Coderleitung 13 an einen Kanaldecoder 7 geführt. Der Kanaldecoder 7 führt unter Verwendung des Soft-Output-Viterbi-Algorithmus (SOVA) eine Kanaldecodierung durch.

Der Soft-Output-Viterby-Algorithmus ist bekannt und z.B. bei Hagenauer "A Viterbi Algorithm with Soft-Decision Outputs and its Applications", Global Telecommunications Conference, Dallas, 1989, S. 1680 ff, beschrieben. Der Kanaldecoder 7 ermittelt für jedes, kanaldecodierte Datum ein entschiedenes Datum $u_i$ und eine Zuverlässigkeitsinformation $L_i$. Das entschiedene Datum $u_i$ wird über eine vierte Coderleitung 14 an einen arithmetischen Decoder 8 geführt. Zusätzlich wird die Zuverlässigkeitsinformation $L_i$ an den arithmetischen Decoder 8 über eine fünfte Coderleitung 15 geleitet. Der arithmetische Decoder 8 führt unter Verwendung des entschiedenen Datums und der Zuverlässigkeitsinformation eine arithmetische Decodierung der Daten durch. Die arithmetisch decodierten Daten werden über eine zweite Datenleitung 16 an eine Datensenke 9 gegeben. Die Datensenke 9 ist zum Beispiel eine Bildwiedergabeeinheit.

Bei einer realen Übertragung von Daten treten Störungen des Übertragungskanals 5 auf. Diese sind in Figur 1 schematisch als Pfeile mit einer Multipliziereinheit bzw. Addiereinheit dargestellt. Diese Störungen können dazu führen, daß im Kanaldecoder 7 ein falsches Datum $u_i$ entschieden wird. Ein Anzeichen dafür ist ein kleiner Wert der Zuverlässigkeitsinformation $L_i$. Die Funktionsweise des arithmetischen Decoders 8 wird anhand der Figur 2 erläutert.

Figur 2 beschreibt in Form eines schematischen Programmablaufes die Funktionsweise des arithmetischen Decoders 8.

Im folgenden wird davon ausgegangen, daß die übertragenen Daten vor dem Kanalencoder 3 einer zyklischen Blockcodierung unterzogen worden sind.

Als Blockcoder wird ein Generatorpolynom mit der Funktion $g(x) = 1 + x + x^3$ verwendet. Hierbei werden für eine vorgegebene Anzahl von Daten drei Prüfbits angefügt.

Deshalb wird bei Programmpunkt 100 eine zyklische Blockcodedecodierung durchgeführt. Dabei wird eine Fehlerdetektion durchgeführt, die eine Aussage darüber erlaubt, ob die übertragenen Daten fehlerhaft übertragen wurden. Zyklische Blockcodes sind z.B. bei S. Lin, " Error Control Coding", Prentice-Hall, 1983, beschrieben. Die Information, ob ein Fehler bei der Übertragung aufgetreten ist, wird in einem Speicher abgelegt. Die zyklisch Blockcode decodierten Daten werden in einen Speicher kopiert. Anschließend werden bei Programmpunkt 101 die zyklisch Blockcode decodierten Daten einer arithmetischen Decodierung unterzogen. Bei dieser arithmetischen Decodierung wird eine Verteilungsdichtefunktion der Daten verwendet, die bei der Datenquelle 1 zuvor gemessen wurde. Die arithmetisch decodierten Daten $x_i$ werden in einem Speicher abgelegt. Der Index i bezeichnet den Zeittakt des Datums. Bei Programmpunkt 102 werden aus den arithmetisch decodierten Daten zeitlich folgende Daten prädiziert.

Bei der Übertragung von Bilddaten eines Bildes werden z.B. die Luminanzwerte pixelweise von links nach rechts und zeilenweise von oben nach unten übertragen. Figur 3 zeigt schematisch einen Bildausschnitt, der aus aufeinanderfolgenden Bildzeilen 20, 21 besteht. Bildzeile 20 weist einen ersten Bildpunkt D 22 und einen zweiten Bildpunkt C 23 auf. Die zweite Bildzeile 21 zeigt einen ersten Bildpunkt B 24 und einen zweiten Bildpunkt A 25. Sind nun die Luminanzwerte des ersten und zweiten Bildpunktes 22, 23 der ersten Zeile 20 und des ersten Bildpunktes 24 der zweiten Bildzeile 21 bekannt, so wird der Luminanzwert des zweiten Bildpunktes 25 der zweiten Bildzeile 21 aus den Luminanzwerten des ersten und zweiten Bildpunktes 22, 23 der ersten Bildzeile und des ersten Bildpunktes 24 der zweiten Bildzeile 21 ermittelt.

Dabei wird eine örtliche lineare Prädiktion dritter Ordnung durchgeführt. Der Bildpunkt A wird mit Hilfe der Bildpunkte B, C und D prädiziert.

Der Luminanzwert $X_A$ im Bildpunkt A wird berechnet nach:

$$\tilde{X}_A = 0.52 * (X_B + X_C) - 0.058 \; X_D \qquad (1)$$

wobei mit $X_B$, $X_C$ und $X_D$ die Luminanzwerte an den Bildpunkten B, C und D bezeichnet sind. Mit $\tilde{X}$ werden die prädizierten Luminanzwerte gekennzeichnet.

Die Wahrscheinlichkeitsdichtefunktion des Prädiktionsfehlers e = X - $\tilde{X}$ wurde gemessen und durch eine Laplace-Verteilung approximiert.

$$p_e = \frac{1}{\sqrt{2}\sigma_e} e^{-(\sqrt{2}|e|/\sigma_e)} \qquad (2)$$

Mit $\sigma_e$ ist die Standardabweichung bezeichnet.

Aus der Laplace-Verteilung $p_e$ läßt sich ein Zuverlässigkeitswert $L_{präd}$ wie folgt berechnen. Repräsentativ für die Prädiktion einer vorgegebenen Anzahl N von Bildpunkten wird eine Mittelwertdifferenz gebildet:

$$e = 1/N \; (X_i - \tilde{X}_i) \qquad (3)$$

Die Wahrscheinlichkeit für eine richtige Prädiktion ist:

$$P_r = p_e(e) \qquad (4)$$

Die Zuverlässigkeit ist dann in Form eines Log-Likelihood-Verhältnisses zu berechnen:

$$L_{präd} = \log [(1 - P_r)/P_r] \qquad (5)$$

Die prädizierten Luminanzwerte $\tilde{x}$, werden in einem Speicher zwischengespeichert.

Beim folgenden Programmpunkt 103 werden die präzidierten

Luminanzwerte $\tilde{x}$, einer arithmetischen Codierung unterzogen. So werden arithmetisch codierte und prädizierte

Luminanzwerte $\tilde{v}_i$ erhalten. Beim folgenden Programmpunkt 104 werden die arithmetisch codierten und prädizierten

Luminanzwerte $\tilde{v}_i$ mit den kanaldecodierten Luminanzwerten $v_i$ des gleichen Zeittaktes i verglichen. Dabei erfolgt die Abfrage, ob der prädizierte, arithmetisch codierte

Luminanzwert $\tilde{v}_i$ gleich dem kanaldecodierten Luminanzwert $v_i$ ist. Ist dies nicht der Fall, so wird nach Programmpunkt 105 verzweigt. Bei Programmpunkt 105 wird eine Änderung der Verteilungsdichtefunktion der Daten, die zur arithmetischen Decodierung verwendet wird, vorgenommen.

Die Änderungen der Verteilungsdichtefunktion wird anhand der Figur 4 beschrieben. Figur 4 zeigt unter a) schematisch eine Verteilungsdichtefunktion der Daten, die z.B. bei der Datenquelle 1 gemessen wurde. Dabei ist ein Wertebereich von 0 bis 1 in einzelne Teilwertebereiche unterteilt. Die Grenzen der Teilwertebereiche werden durch kumulative Wahrscheinlichkeiten $P_i$ gebildet. Die kumulativen Wahrscheinlichkeiten $P_i$ berechnen sich folgendermaßen:

$$P_i = \sum_{j=1}^{i} P_j; \; i=1,\ldots,N-1; \; P_O=0, P_N=1 \qquad (6)$$

wobei mit $p_j$ die Auftrittswahrscheinlichkeit eines Symboles $s_i$ der Datenquelle 1 bezeichnet ist. Jede Folge von Symbolen $s_i$ wird mit Hilfe der arithmetischen Codierung einer reellen Zahl C zugeordnet. Die reelle Zahl C wird nach folgender Formel

$$C_{i+1} = C_i + I_i \cdot P_{i+1}$$

gebildet.

Das Intervall $I_i$ stellt den Wertebereich von 0 bis 1 dar. Die folgenden Intervalle $I_{i+1}$ werden nach folgender Formel:

$$I_{i+1} = I_i \cdot P_i$$

bestimmt.

Für die Decodierung wird die reelle Zahl $C_i$ mit den kumulativen Wahrscheinlichkeiten $P_i$ verglichen. Aus dem folgenden Vergleich ergibt sich, daß das Symbol $s_i$ decodiert wurde, wenn $P_i < C_i < P_{i+1}$ ist. Daraufhin wird

$$C_{i+1} = C_i - P_i$$

und ein neues Intervall

$$I_{i+1} = I_i/P_i$$

gebildet, wobei das neue Intervall wieder entsprechend den kumulativen Wahrscheinlichkeiten unterteilt ist. Die neue reelle Zahl $C_{i+1}$ wird wiederum mit den kumulativen Wahrscheinlichkeiten des neuen Intervalls $I_{i+1}$ verglichen und ein weiteres Symbol $s_{i+1}$ decodiert.

Es lassen sich bei der Verwendung binärer Symbole der Datenquelle 1 zwei Fälle unterscheiden. Ist das entschiedene Datum $u_j = 0$, so gibt die entsprechende Zuverlässigkeitsinformation $L_j$ die Zuverlässigkeit dafür an, daß eine gesendete zweite Anzahl $C_2$ an Symbolen länger ist als eine empfangene erste Anzahl $C_1$ an Symbolen, da ja $u_j = 0$ anstelle von $u_j = 1$ falsch detektiert sein könnte.

Die empfangene Anzahl $C_1$ ist in Figur 4 b) schematisch dargestellt. Die gesendete Anzahl $C_2$ ist in Figur 4c) schematisch dargestellt. In diesem Fall wird, wenn die

Anzahl $C_1$ der empfangenen Symbole in den Teilwertebereich zwischen $P_i$ und $P_{i+1}$ der Verteilungsdichtefunktion fällt, der kumulativen Wahrscheinlichkeit $P_{i+1}$ ein neuer Wert $P_{i+1}$, zugewiesen werden, wobei die Zuverlässigkeitsinformation dabei berücksichtigt wird. Ist umgekehrt das entschiedene Datum $u_j$ gleich 1, so bezeichnet die entsprechende Zuverlässigkeitsinformation $L_j$, daß die Anzahl $C_2$ der gesendeten Symbole $u_i$ kleiner/gleich der Anzahl $C_1$ der empfangenen Symbole $u_i$ ist, da ja, obwohl eine 1 detektiert wurde, eine 0 gesendet worden sein kann. Dies bedeutet, daß die kumulative Wahrscheinlichkeit $P_i$ unter Berücksichtigung der Zuverlässigkeitsinformation aktualisiert werden muß. Dieser Fall ist in den Figuren 4 d-f dargestellte Die Aktualisierung der kumulativen Wahrscheinlichkeiten $P_i$ bzw. $P_{i+1}$ erfolgt durch folgende Formeln:

$$P_{i,neu} = (1-L_j) (P_{i,alt}+2^{-j}) + L_j P_{i,alt} \tag{7}$$

$$P_{i+1,neu} = (1-L_j) (P_{i+1,alt-}2^{-j}) + L_j P_{i+1,alt} \tag{8}$$

wobei der Index j eine Laufvariable darstellt, mit der die Daten der Datenquelle 1 innerhalb einer vorgegebenen Anzahl von Datenbits, z.B. einer Zeile eines Bildes, numeriert sind.

Ist das Datum $u_j$ sicher decodiert worden, dann ergibt sich für die Zuverlässigkeitsinformation $L_j$ der Wert 1, d.h. die kumulativen Wahrscheinlichkeiten $P_i$ und $P_{i+1}$ behalten ihre Werte bei. Im Falle einer extrem unsicheren Kanaldecodierung erhält die Zuverlässigkeitsinformation $L_j$ den Wert 0, d.h. es erfolgt eine Aktualisierung nach den Formeln (7) und (8).

Diese Aktualisierung entspricht bei binären Daten dem Umkippen eines Bits bzw. einer ganzzahligen Anzahl von Datenbits. Nimmt die Zuverlässigkeitsinformation $L_j$ Zwischenwerte an, so entspricht die beschriebene Aktualisierung dem Umkippen einer nicht ganzzahligen Anzahl von Datenbits. Es muß dafür gesorgt werden, daß durch die Aktualisierung der Verteilungsdichtefunktion keine unmöglichen Ereignisse auftreten. Die Werte der kumulativen Wahrscheinlichkeiten $P_i$ sind der Größe nach geordnet:

$$P_1 < P_2 < ...P_{i-1} < P_i < P_{i+1} < P_n.$$

Diese Ordnung muß auch nach der Aktualisierung beibehalten werden. Damit diese Bedingung immer erfüllt bleibt, ist eine Zwischenvariable a eingeführt worden, die Werte zwischen 0 und 1 einnehmen kann. Mit Hilfe der Zwischenvariablen 1äßt sich die Gleichung (7) wie folgt umschreiben:

$$P_{i,neu} = (1-L_j) [(1-a)P_{i-1} + a P_{i+1}] + L_j P_{i,alt} \tag{9}$$

Mit

$$a = \begin{cases} 0 & (P_{i,alt} + 2^{-j}) < P_{t-1} \\ \left[ \dfrac{(P_{i,alt} + 2^{-j}) - P_{i-1}}{P_{i+1} - P^{i-1}} \right] & P_{i-1} < (P_{i,alt} + 2^{-j}) \leq P_{i+1} \\ 1 & P_{i+1} < (P_{i,alt} + 2^{-j}) \end{cases}$$

$$P_{i+1,neu} = (1-L_j) [(1-b)P_i + bP_{i+2}] + L_j P_{i+1,alt} \tag{10}$$

mit

$$b = \begin{cases} 0 & (P_{i+1,alt} - 2^{-j}) < P_i \\ \left[ \dfrac{(P_{i+1,alt} - 2^{-j}) - P_i}{P_{i+2} - P_i} \right] & P_i < (P_{i+1,alt} - 2^{-j}) \leq P_{i+2} \\ 1 & P_{i+2} < (P_{i+1,alt} - 2^{-j}) \end{cases}$$

Die beschriebenen Formeln zur Aktualisierung der Verteilungsdichtefunktion können je nach Anwendung auch anders lauten.

Ergibt die Abfrage bei Programmpunkt 104, daß das prädizierte und arithmetisch codierte Datum $\tilde{v}_i$ gleich dem kanaldecodierten Datum $v_i$ ist, so wird nach Programmpunkt 114 verzweigt. Bei Programmpunkt 114 erfolgt eine arithmetische Decodierung des kanaldecodierten Datums $v_i$ mit der ersten Verteilungsdichtefunktion. Anschließend wird nach Programmpunkt 107 verzweigt.

Bei Programmpunkt 106 erfolgt eine arithmetische Decodierung des kanaldecodierten Datums $v_i$ mit der veränderten Verteilungsdichtefunktion. Stellt das kanaldecodierte Datum eine 0 dar, so wird bei der arithmetischen Decodierung eine neue obere Grenze $P_{i+1}$ entsprechend Formel (8) oder (10) verwendet. Stellt das kanaldecodierte Datum $v_i$ eine 1 dar, so wird bei der arithmetischen Decodierung eine neue untere Grenze $P_i$ entsprechend Formel (7) oder (9) verwendet. Anschließend erfolgt bei Programmpunkt 107 die Abspeicherung des arithmetisch decodierten Datums als erstes entschiedenes Datum $u_i$ (1).

Anschließend erfolgt bei Programmpunkt 115 die Abfrage, ob eine weitere Verarbeitung des ersten entschiedenen Datums erfolgen soll oder nicht. Soll bei einfachen Verfahren keine weitere Verarbeitung des ersten entschiedenen Datums erfolgen, so wird nach Programmpunkt 100 zurückverzweigt. Soll jedoch eine weitere Bearbeitung erfolgen, so wird bei Programmpunkt 108 aus einer vorgegebenen Anzahl abgespeicherter prädizierter Daten $x_i$ eine zweite Zuverlässigkeitsinformation $L_{xi}$ mit der Formel (5) berechnet und abgespeichert.

Beim folgenden Programmpunkt 109 wird aus der ersten Zuverlässigkeitsinformation $L_i$ der entschiedenen Daten ein Maß für die Fehlerfreiheit einer vorgegebenen Anzahl an Daten in Form einer Entropie H (L) der Zuverlässigkeitsinformationen einer vorgegebenen Anzahl N an Datenbits unter Verwendung der folgenden Formel ermittelt:

$$H(L) = - \sum_{n} p(L_n) \; \log_2 \; (p(Ln),$$

wobei $p(L_n)$ die Auftrittswahrscheinlichkeit des Wertes $L_n$ bezeichnet. Mit L ist ein Vektor entsprechend der folgenden Formel:

$$L = (L_1, L_2, ..., L_N),$$

bezeichnet. In diesem Ausführungsbeispiel wird als vorgegebene Anzahl N an Datenbits die Anzahl an Datenbits verwendet, die zur Darstellung der Bildpunkte eines Bildes notwendig ist. Aus zeitlich aufeinanderfolgenden Bildzeilen wird ein Aktualisierungswert E nach folgender Formel $E_{i, (i-1)} = 10 \log_{10} H(L_i)/H(L_{i-1})$ berechnet. Dabei bedeutet der Index i bzw. i-1 die Bildzeile i bzw. i-1. $L_i$ stellt in diesem Fall eine über die Bildzeile i gemittelte Zuverlässigkeitsinformation dar. Der Aktualisierungswert wird zwischengespeichert.

Bei Programmpunkt 110 wird das arithmetisch decodierte Datum $x_i$ als zweites entschiedenes Datum $u_i$ (1) mit der entsprechenden Zuverlässigkeitsinformation $L_i$ ausgewählt, wenn das Maß für die Fehlerfreiheit (Fehlerrate der BCH-Decodierung) unter einer vorgegebenen Schwelle liegt und wenn der Aktualisierungswert kleiner als eine vorgegebene Schwelle ist, und wenn die aus dem prädizierten Datum ermittelte zweite Zuverlässigkeitsinformation $L_{xi}$ kleiner ist als die erste Zuverlässigkeitsinformation $L_i$. In allen anderen Fällen wird das prädizierte Datum $\tilde{x}$, und die zweite Zuverlässigkeitsinformation $L_{xi}$ als zweites entschiedenes Datum ermittelt. An Stelle der ersten über eine Bildzeile gemittelten Zuverlässigkeitsinformation $L_i$ kann auch für jeden Bildpunkt eine Zuverlässigkeitsinformation verwendet werden. Der Aktualisierungswert Ei, i-1 wird dann auch für jeden Bildpunkt gebildet.

Daraufhin folgt Programmpunkt 111, bei dem aus dem ersten entschiedenen Datum $x_i$ unter Verwendung einer Laplace-Verteilung eine dritte Zuverlässigkeitsinformation nach Formel (5) ermittelt wird, d.h. aus dem Datum, das nach der geänderten Verteilungsdichtefunktion arithmetisch decodiert worden ist, wird die dritte Zuverlässigkeitsinformation gebildet. Anschließend erfolgt bei Programmpunkt 112 ein Vergleich der dritten Zuverlässigkeitsinformation mit der im Programmschritt 110 ausgewählten ersten oder zweiten Zuverlässigkeitsinformation, wobei als drittes entschiedenes Datum das Datum mit der größten Zuverlässigkeitsinformation ausgewählt wird. Anschließend wird bei Programmpunkt 113 das dritte entschiedene Datum an die Datensenke 9 weitergegeben und nach Programmpunkt 100 zurückverzweigt.

Bei einfachen Kanalcodierungsverfahren kann die zyklische Blockcodierung entfallen.

Anhand des folgenden einfachen Beispiels wird das Prinzip der arithmetischen Codierung beschrieben.

Wir betrachten ein Alphabet mit N = 5 Symbolen A,B,C,D und E mit den folgenden Auftritts- $p_A$ und Kumulativwahrscheinlichkeiten $P_A$:

| | |
|---|---|
| $p_A = 0.07;$ | $P_A = 0.00$ |
| $p_B = 0.30$ | $P_B = 0.07$ |
| $p_C = 0.09$ | $P_C = 0.37$ |
| $p_D = 0.42$ | $P_D = 0.46$ |
| $p_E = 0.12$ | $P_E = 0.88$ |

Nun bilden wir den arithmetischen Code für die Symbolfolge CBD.

Für das Symbol C ergibt sich als Anfangspunkt $C_c$ und als Intervall $I_c$ nach folgender Berechnung:

$$C_c = C_0 + I_0 \; {}^*P_c$$

$$= 0.0 + 1.0 * 0.37 = 0.37$$

$$I_c = I_0 * p_c$$

$$= 1.0 * 0.09 = 0.09$$

Für den Anfangswert $C_0$ wurde 0.0 und für das Anfangsintervall $I_0$ wurde 1.0 eingesetzt.

Für das Symbol B, das nach dem Symbol C folgt ergeben sich für den Anfangspunkt $C_{CB}$ und für das Intervall $I_{CB}$ folgende Werte:

$$C_{CB} = C_c + I_c * p_B$$

$$= 0.37 + 0.09 * 0.07 = 0.3763$$

$$I_{CB} = I_C * p_B$$

$$= 0.09 * 0.30 = 0.027$$

Für das Symbol D, das auf die Symbole C und B folgt, ergeben sich für den Anfangspunkt $C_{CBD}$ und das Intervall $I_{CBC}$ folgende Werte:

$$C_{CBD} = C_{CB} + I_{CB} * P_D$$

$$= 0.3763 + 0.027 * 0.46 = 0.38872$$

$$I_{CBD} = I_{CB} * p_D$$

$$= 0.027 * 0.42 = 0.01134$$

Wie man aus diesem Beispiel erkennen kann, ist es notwendig ein End Of String (EOS) Codewort einzuführen. Die binäre Darstellung von $C_{CBD} = 0.38872 = (0.011000111...)$ muß übertragen werden. Da aber jede reelle Zahl im Bereich zwischen 0.38872 und 0.40006 die selbe Nachricht darstellt, muß nur die binäre Zahl 011000111 übertragen werden.

Der Empfänger erhält die Bitfolge $C_{emp} = 011000111...$ Durch Intervallsuche erhalten wir:

$$P_C </= C_{emp} = 0.38872 < P_D \rightarrow \text{Das erste Symbol ist C}$$

$$C_{neu} = (C_{alt} - P_C)/P_D = 0.01872/0.09 = 0.208$$

$$P_B </= C_{neu} = 0{,}208 < P_C \rightarrow \text{Das zweite Symbol ist B}$$

$$C_{neu} = (C_{alt} - P_B)/p_B = 0.138/0.3 = 0.46$$

$$P_D </= C_{neu} = 0.46 < P_E \rightarrow \text{Das letzte Symbol ist D.}$$

Auf diese Weise wird aus der Bitfolge $C_{emp} = 011000111$ die Symbolfolge CBD durch arithmetische Decodierung ermittelt.

**Patentansprüche**

**1.** Verfahren zur arithmetischen Decodierung von Daten, wobei eine ermittelte Verteilungsdichtefunktion der Daten, die zur arithmetischen Decodierung der Daten verwendet wird, geändert wird, **dadurch gekennzeichnet, daß** die kanalcodierten Daten nach einem Soft-Viterbi-Algorithmus kanaldecodiert (7) werden und erste Zuverlässigkeitsinformationen ($L_i$) ermittelt werden, daß die kanaldecodierten Daten gespeichert werden, daß aus den kanaldecodierten Daten arithmetisch decodierte Daten ermittelt werden (101), daß aus einer vorgegebenen Anzahl der arithmetisch decodierten Daten Daten prädiziert werden (102), daß die prädizierten Daten arithmetisch codiert werden und mit den entsprechenden, d.h. örtlich oder zeitlich gleichen, gespeicherten kanaldecodierten Daten verglichen werden (104), daß bei Übereinstimmung zwischen prädizierten und kanaldecodierten Daten eine arithmetische Decodierung mit einer unveränderten Verteilungsdichtefunktion und bei keiner Übereinstimmung zwischen pradizierten und kanaldecodierten Daten eine arithmetische Decodierung mit einer veränderten Verteilungsfunktion erfolgt (105).

**2.** Verfahren nach Anspruch 1, **dadurch gekennzeichnet, daß** die veränderte Verteilungsdichtefunktion (105) dadurch gewonnen wird, daß bei einem kleinen Wert des kanaldecodierten Datums und einer kleinen ersten Zuverlässigkeitsinformation ($L_i$) ein oberer Wert eines Wertebereiches der Verteilungsdichtefunktion, in den das kanaldecodierte Datum fällt, hin zu kleineren Werten geändert wird, und daß bei einem großen Wert des kanaldecodierten Datums und einer kleinen ersten Zuverlässigkeitsinformation ($L_i$) ein unterer Wert eines Wertebereiches der Verteilungsdichtefunktion, in den das kanaldecodierte Datum fällt, hin zu größeren Werten geändert wird.

**3.** Verfahren nach Anspruch 1 oder 2, **dadurch gekennzeichnet, daß** aus einer vorgegebenen Anzahl prädizierter Daten eine zweite Zuverlässigkeitsinformation ($L_{xi}$) ermittelt wird, daß aus der ersten Zuverlässigkeitsinformation ($L_i$) ein Maß für die Fehlerfreiheit einer vorgegebenen Anzahl an Daten in Form einer Entropie berechnet wird, daß das arithmetisch decodierte Datum und die erste Zuverlässigkeitsinformation ($L_i$) ausgewählt werden, wenn das Maß für die Fehlerfreiheit über einer vorgegebenen Schwelle liegt und die zweite Zuverlässigkeitsinformation ($L_{xi}$) kleiner als die erste Zuverlässigkeitsinformation ($L_i$) ist, und daß das prädizierte Datum und die zweite Zuverlässigkeitsinformation ($L_{xi}$) in den anderen Fällen ausgewählt werden (110), daß aus dem Datum, das nach der geänderten Verteilungsdichtefunktion arithmetisch decodiert worden ist, eine dritte Zuverlassigkeitsinformation gebildet wird (111), daß die ausgewählte erste oder zweite Zuverlässigkeitsinformation mit der dritten Zuverlässigkeitsinformation verglichen wird (112), und daß das Datum mit der größeren Zuverlässigkeitsinformation als entschiedenes Datum verwendet wird.

**4.** Verfahren nach Anspruch 3, **dadurch gekennzeichnet, daß** die kanalcodierten Daten mittels zyklischer Blockcodes (BCH) codiert sind und unter Verwendung der zyklischen Blockcodes (BCH) decodiert werden, daß bei der zyklischen Blockcode-Decodierung eine Fehlerdetektion durchgeführt wird, und daß das arithmetisch decodierte Datum nur als entschiedenes Datum ausgewählt wird, wenn die detektierte Anzahl an Fehlern bei der Fehlerdetektion anhand der Blockcode-Decodierung unter einer vorgegebenen Schwelle liegt.

**5.** Verfahren nach einem der Ansprüche 1 bis 4, **dadurch gekennzeichnet, daß** die erste Zuverlassigkeitsinformation ($L_i$) über eine vorgegebene Anzahl von Daten gemittelt wird.

**6.** Verfahren nach einem der Ansprüche 3 bis 5, **dadurch gekennzeichnet, daß** die zweite und die dritte Zuverlassigkeitsinformation ($L_{xi}$, 112) über eine vorgegebene Anzahl von Daten gemittelt wird.

**7.** Verfahren nach Anspruch 3 bis 5, **dadurch gekennzeichnet, daß** die zweite oder dritte zuverlassigkeitsinformation ($L_{xi}$, 112) über eine vorgegebene Anzahl von Daten gemittelt wird.

**Claims**

**1.** Method for arithmetic decoding of data, a determined distribution density function of the data which is used for the arithmetic decoding of the data being changed, **characterized in that** the channel-coded data are channel-decoded (7) using a soft Viterbi algorithm, and first reliability information items ($L_i$) are determined, **in that** the channel-decoded data are stored, **in that** arithmetically decoded data are determined (101) from the channel-decoded data, **in that** data are predicted (102) from a prescribed number of the arithmetically decoded data, **in that** the predicted data are arithmetically coded and compared (104) with the corresponding, that is to say spatially or temporally identical, stored channel-decoded data, and **in that** an arithmetic decoding is performed (105) with an unchanged distribution density function in the event of correspondence between predicted and channel-decoded data, and an arithmetic decoding is performed (105) with a changed distribution function in the event of no correspondence between predicted and channel-decoded data.

**2.** Method according to Claim 1, **characterized in that** the changed distribution density function (105) is obtained by virtue of the fact that in the event of a small value of the channel-decoded data item and of a small first reliability information item ($L_i$) an upper value of a value range of the distribution density function, into which the channel-decoded data item falls, is changed towards smaller values, and **in that** in the event of a large value of the channel-decoded data item and a small first reliability information item ($L_i$) a lower value of a value range of the distribution density function into which the channel-decoded data item falls is changed towards larger values.

**3.** Method according to Claim 1 or 2, **characterized in that** a second reliability information item ($L_{xi}$) is determined from a prescribed number of predicted data, **in that** a measure of the freedom from error of a prescribed number of data is calculated in the form of an entropy from the first reliability information item ($L_i$), **in that** the arithmetically decoded data item and the first reliability information item ($L_i$) are selected when the measure of the freedom from error is above a prescribed threshold and the second reliability information item ($L_{xi}$) is smaller than the first reliability information item ($L_i$), and **in that** the predicted data item and the second reliability information item ($L_{xi}$) are selected (110) in the other cases, **in that** a third reliability information item is formed (111) from the data item which was arithmetically decoded using the changed distribution density function, **in that** the selected first or second reliability information item is compared (112) with the third reliability information item, and **in that** the data item with the largest reliability information item is used as decided data item.

**4.** Method according to Claim 3, **characterized in that** the channel-coded data items are coded by means of cyclic block codes (BCH) and decoded using the cyclic block codes (BCH), **in that** error detection is carried out during the cyclic block code decoding, and **in that** the arithmetically decoded data item is selected as decided data item only when the detected number of errors during the error detection by means of the block code decoding is below a prescribed threshold.

**5.** Method according to one of Claims 1 to 4, **characterized in that** the first reliability information item ($L_i$) is averaged over a prescribed number of data items.

**6.** Method according to one of Claims 3 to 5, **characterized in that** the second and the third reliability information items ($L_{xi}$, 112) are averaged over a prescribed number of data items.

**7.** Method according to Claims 3 to 5, **characterized in that** the second or third reliability information item ($L_{xi}$, 112) is averaged over a prescribed number of data items.

**Revendications**

**1.** Procédé de décodage arithmétique de données selon lequel on modifie une fonction de densité de distribution déterminée des données utilisée pour le décodage arithmétique des données,
**caractérisé en ce qu'**
on effectue un décodage canal (7) des données en codage canal selon un algorithme Viterbi programmé, on détermine des premières informations de fiabilité ($L_i$), on enregistre les données en code canal, à partir des données en code canal on détermine arithmétiquement les données décodées (101), à partir d'un nombre prédéterminé de données à décoder arithmétiquement on prédit des données (102), on code arithmétiquement les données prédites et on compare avec les données en codage canal (104), correspondantes, enregistrées, c'est-à-dire égales dans le temps ou dans l'espace, et en cas de concordance entre les données prédites et les données à décodage canal on effectue un décodage arithmétique avec une fonction de densité de distribution inchangée et en cas de non concordance entre les données prédites et les données de décodage canal on fait un décodage arithmétique avec une fonction de répartition modifiée (105).

**2.** Procédé selon la revendication 1,
**caractérisé en ce qu'**
on obtient la fonction de densité de distribution modifiée (105) **en ce que** pour une petite valeur de la donnée en décodage canal et pour une petite première information de fiabilité ($L_i$) on modifie une valeur supérieure d'une plage de valeur de la fonction de densité de distribution dans laquelle tombe la donnée de décodage canal, vers les valeurs plus petites et **en ce que** pour une grande valeur de la donnée de décodage canal et pour une petite première information de fiabilité ($L_i$), on modifie une valeur inférieure de la fonction de densité de distribution, plage dans laquelle tombe la donnée de décodage canal, vers les grandes valeurs.

**3.** Procédé selon l'une quelconque des revendications 1 ou 2,
**caractérisé en ce qu'**
à partir d'un nombre prédéterminé de données prédites on détermine une seconde information de fiabilité ($L_{xi}$), à partir de la première information de fiabilité ($L_i$) on calcule une mesure de la liberté d'erreur d'un nombre prédéterminé de données sous la forme d'une entropie, on sélectionne la donnée décodée arithmétique et la première information de fiabilité ($L_i$) si la mesure pour la liberté de défaut dépasse un seuil prédéterminé et la seconde information de fiabilité ($L_{xi}$) est inférieure à la première information de fiabilité ($L_i$) et la donnée prédite et la seconde information de fiabilité ($L_{xi}$) sont sélectionnées dans les autres cas (110), à partir de la donnée qui a été décodée arithmétiquement selon la fonction de distribution de densité modifiée, on forme une troisième information de fiabilité (111), on compare la première et la seconde information de fiabilité sélectionnées avec la troisième information de fiabilité (112) et on utilise la donnée ayant la plus grande information de fiabilité comme donnée décidée.

**4.** Procédé selon la revendication 3,
**caractérisé en ce qu'**
on code les données en code canal par un code bloc cyclique (BCH) et en utilisant ce code bloc cyclique on décode (BCH) et pour le décodage de code bloc cyclique on effectue une détection d'erreur et **en ce qu'**on sélectionne la donnée à décodage arithmétique seulement comme donnée décisive si le nombre détecté d'erreurs dans la détection d'erreurs avec le décodage de code bloc est inférieur à un seuil prédéterminé.

**5.** Procédé selon l'une quelconque des revendications 1 à 4,
**caractérisé en ce qu'**
on fait la moyenne de la première information de fiabilité ($L_i$) pour un nombre prédéterminé de données.

**6.** Procédé selon l'une quelconque des revendications 3 à 5,
**caractérisé en ce qu'**
on fait la moyenne de la seconde et de la troisième information de fiabilité ($L_{xi}$, 112) pour un nombre prédéterminé de données.

**7.** Procédé selon l'une quelconque des revendications 3 à 5,
**caractérisé en ce qu'**
on fait la moyenne de la seconde et de la troisième information de fiabilité ($L_{xi}$, 112) sur un nombre prédéterminé de données.

Fig. 1

Fig. 3

Fig. 4a  0 ··· $P_i-1$  $P_i$  $P_i+1$  $P_i+2$ ··· 1

Fig. 4b  C1

Fig. 4c  C2

Fig. 4d  0 ··· $P_i-1$  $P_j$  $P_j+1$  $P_j+2$ ··· 1

Fig. 4e  C1

Fig. 4f  C2

EP 0 697 770 B1

Fig. 2